(19) Europäisches Patentamt

European Patent Office

Office européen des brevets

(11) **EP 4 592 822 A2**

(12) **EUROPEAN PATENT APPLICATION**

(43) Date of publication:
**30.07.2025 Bulletin 2025/31**

(21) Application number: **25182135.1**

(22) Date of filing: **11.06.2025**

(51) International Patent Classification (IPC):
**G06F 7/483** (2006.01)  **G06F 7/499** (2006.01)
**H03M 7/24** (2006.01)

(52) Cooperative Patent Classification (CPC):
**G06F 7/483; G06F 7/49947; H03M 7/24**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **05.09.2024 CN 202411244839**

(71) Applicant: **KunlunXin Technology (Beijing)
Company Limited
Haidian District
Beijing 100101 (CN)**

(72) Inventors:
• **BAO, Hexin**
**Beijing, 100101 (CN)**
• **DU, Xueliang**
**Beijing, 100101 (CN)**
• **LI, Bowen**
**Beijing, 100101 (CN)**

(74) Representative: **von Tietzen und Hennig, Nikolaus
Lorenz Seidler Gossel
Rechtsanwälte Patentanwälte
Partnerschaft mbB
Widenmayerstraße 23
80538 München (DE)**

(54) **FLOATING-POINT CONVERSION METHOD, APPARATUS, CHIP, DEVICE AND MEDIUM**

(57) A method includes: determining the exponent data and mantissa data of the floating-point number; in response to the floating-point conversion being a floating-point rounding normalization, performing: determining, based on the exponent data and the mantissa data, the exponent value of the floating-point number; concatenating, in response to the exponent value being less than the bit width of the mantissa data, first padding data to the left of the mantissa data to determine first concatenated data; performing, based on the exponent value, a first left-shift operation on the first concatenated data to determine first intermediate data; determining, based on the exponent data and the mantissa data, a carry amount of the floating-point number; performing, in response to the carry amount of the floating-point number indicating that a carry occurs during the floating-point rounding normalization, a carry operation on a first part of the first intermediate data; determining a normalized floating-point number.

<u>200</u>

determine, for a floating-point number to be converted, the exponent data and the mantissa data of the floating-point number ~ S201

whether the floating-point conversion is a floating-point rounding normalization? S202

YES

determine, based on the exponent data and the mantissa data, the exponent value of the floating-point number ~ S203

concatenate, in response to the exponent value of the floating-point number being less than the bit width of the mantissa data, first padding data to the left of the mantissa data to determine first concatenated data ~ S204

perform, based on the exponent value of the floating-point number, a first left-shift operation on the first concatenated data to determine first intermediate data ~ S205

determine, based on the exponent value and the mantissa data, a carry amount of the floating-point number ~ S206

perform, in response to the carry amount of the floating-point number indicating that a carry occurs during the floating-point rounding normalization, a carry operation on a first part of the first intermediate data to determine second intermediate data and an overflow variable ~ S207

determine, based on the exponent value of the floating-point number, the second intermediate data and the overflow variable, a normalized floating-point number corresponding to the floating-point number ~ S208

**FIG. 2**

EP 4 592 822 A2

**Description**

## TECHNICAL FIELD

The present disclosure relates to the field of computer technology, particularly to the fields of data processing and chip technology, and specifically to a method, an apparatus, a chip, an electronic device, a computer-readable storage medium, and a computer program product for floating-point conversion.

## BACKGROUND

Artificial intelligence is the discipline that studies how to enable computers to simulate certain thinking processes and intelligent behaviors of a human being (such as learning, reasoning, thinking, planning, etc.), including both hardware-level and software-level technologies. The artificial intelligence hardware technologies generally include technologies such as sensors, special artificial intelligence chips, cloud computing, distributed storage, big data processing, and the like; the artificial intelligence software technologies mainly include computer vision technology, speech recognition technology, natural language processing technology, machine learning/deep learning, big data processing technology, knowledge diagram technology and other major technological directions.

In modern computing devices, floating-point numbers are used to represent large amounts of data and to perform complex calculations. In some computational scenarios, it is desirable to reduce the precision of floating-point numbers (e.g., by rounding the mantissa of the floating-point number to reduce the precision of the floating-point number) in order to meet the requirements of subsequent processing. For example, in image processing or signal processing, rounding the mantissa may be adopted to reduce computational and storage overhead. The methods described in this section are not necessarily methods that have been previously conceived or employed. Unless otherwise indicated, it should not be assumed that any method described in this section is considered to be the prior art only due to its inclusion in this section. Similarly, the problems mentioned in this section should not be assumed to be recognized in any prior art unless otherwise indicated.

## SUMMARY

The present disclosure provides a method for floating-point conversion, an apparatus for floating-point conversion, a chip, an electronic device, a computer-readable storage medium, and a computer program product.

According to one aspect of the present disclosure, there is provided a method for floating-point conversion, comprising: determining, for a floating-point number to be converted, the exponent data and mantissa data of the floating-point number; and performing, in response to the conversion being a floating-point rounding normalization: determining, based on the exponent data and the mantissa data, the exponent value of the floating-point number, wherein the exponent value of the floating-point number is the corresponding power value of the floating-point number; concatenating, in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data; performing, based on the exponent value of the floating-point number, a first left-shift operation on the first concatenated data to determine first intermediate data; determining, based on the exponent value and the mantissa data of the floating-point number, a carry amount of the floating-point number, wherein the carry amount of the floating-point number indicates whether a carry occurs during the floating-point rounding normalization; performing, in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization; and determining, based on the exponent value of the floating-point number, the second intermediate data and the overflow variable, a normalized floating-point number corresponding to the floating-point number.

According to an aspect of the present disclosure, there is provided an apparatus for floating-point conversion, comprising: a preprocessing module configured to: determine, for a floating-point number to be converted, the exponent data and mantissa data of the floating-point number; and a floating-point normalization module, comprising: a first data determination unit configured to: determine, based on the exponent data and the mantissa data, the exponent value of the floating-point number, wherein the exponent value of the floating-point number is the corresponding power value of the floating-point number; a first data concatenating unit configured to: concatenate, in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data; a first left-shift unit configured to: perform, based on the exponent value of the floating-point number, a first left-shift operation on the first concatenated data to determine first intermediate data; a carry amount determination unit configured to: determine, based on the exponent value and the mantissa data of the floating-point number, a carry amount of the floating-point number, wherein the carry amount of the floating-point number indicates whether a carry occurs during the floating-point rounding normalization; a first carry unit configured to: perform, in response to the carry amount of the floating-point number indicating that a carry occurs during the floating-point rounding normalization, a carry operation on the first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization; and a first floating-point number determination unit configured to: determine, based on the exponent value of the floating-point number, the second intermediate data and the overflow variable, a normalized floating-point number corresponding to the floating-point number.

According to one aspect of the present disclosure, there is provided a chip, comprising an apparatus for floating-point conversion as described above.

According to one aspect of the present disclosure, there is provided a computer program product, the computer program product comprising program code portions for performing the floating-point conversion method described in the present disclosure when the computer program product is executed on one or more computing devices..

According to one or more embodiments of the present disclosure, it is achieved that a floating-point number with higher mantissa precision is directly converted to a floating-point number with lower mantissa precision during floating-point rounding normalization without converting the floating-point number with higher mantissa precision to an integer number first and then to a floating-point number with lower mantissa precision, and it is possible to determine whether the mantissa of the floating-point number has undergone a carry overflow due to a rounding carry, thereby achieving floating-point rounding normalization accurately and efficiently.

It should be understood that the content described in this section is not intended to identify key or important features of the aspects of the present disclosure, nor is it intended to limit the scope of the present disclosure. Other features of the present disclosure will become readily understood from the following description.

## BRIEF DESCRIPTION OF THE DRAWINGS

The drawings exemplarily illustrate aspects and constitute a part of the specification, and are used in conjunction with the textual description of the specification to explain the example implementations of the aspects. The illustrated aspects are for illustrative purposes only and do not limit the scope of the claims. Throughout the drawings, like reference numerals refer to similar but not necessarily identical elements.

FIG. 1 illustrates a schematic diagram of an example system in which various methods described herein can be implemented according to example aspects of the present disclosure;

FIG. 2 illustrates a flowchart of a method for floating-point conversion according to example embodiments of the present disclosure;

FIGS. 3A-3B illustrate a schematic diagram of a process of performing a first left-shift operation on first concatenated data according to example aspects of the present disclosure;

FIGS. 4A-4D illustrate a schematic diagram of a process of performing a carry operation on a first part of first intermediate data according to example aspects of the present disclosure;

FIGS. 5A-5E illustrate a schematic diagram of a process of performing a carry operation on a first part of first intermediate data according to example aspects of the present disclosure;

FIGS. 6A-6D illustrate a schematic diagram of a process for determining the mantissa data of a normalized floating-point number according to example aspects of the present disclosure;

FIGS. 7A-7B illustrate a flowchart of a method for floating-point conversion according to example aspects of the present disclosure;

FIGS. 8A-8B illustrate a schematic diagram of a process of performing a third left-shift operation on second concatenated data according to example aspects of the present disclosure;

FIG. 9 illustrates a structural schematic diagram of an apparatus for floating-point conversion according to example aspects of the present disclosure;

FIG. 10 illustrates a structural block diagram of an example electronic device that can be used to implement aspects of the present disclosure.

## DETAILED DESCRIPTION

Example aspects of the present disclosure are described below with reference to the accompanying drawings, which include various details of the aspects of the present disclosure to facilitate understanding, and should be considered as example only. Therefore, those of ordinary skill in the art should realize that various changes and modifications may be made to the aspects described herein without departing from the scope of the present disclosure. Similarly, descriptions of well-known functions and structures are omitted in the following description for the purpose of clarity and conciseness.

In the present disclosure, unless otherwise specified, the terms "first", "second" and the like are used to describe various elements and are not intended to limit the positional relationship, timing relationship, or importance relationship of these elements, and such terms are only used to distinguish one element from another. In some examples, the first element and the second element may refer to the same instance of the element, while in some cases they may also refer to different instances based on the description of the context.

The terminology used in the description of the various examples in this disclosure is for the purpose of describing particular examples only and is not intended to be limiting. Unless the context clearly indicates otherwise, if the number of elements is not specifically defined, the element may be one or more. In addition, the terms "and/or" used in the present disclosure encompass any one of the listed items and all possible combinations thereof.

Aspects of the present disclosure will be described in detail below with reference to the accompanying drawings.

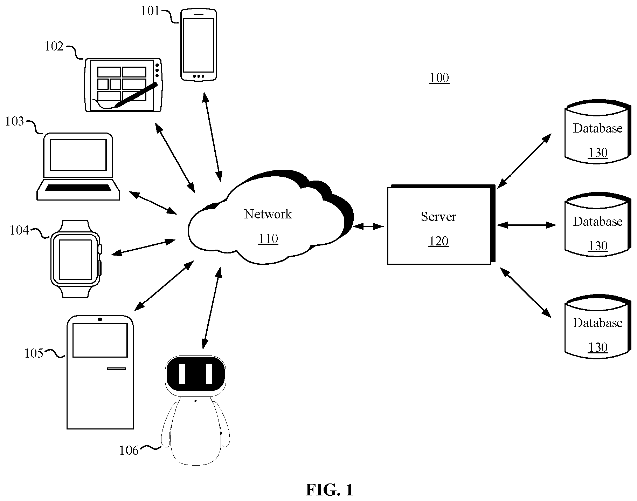

FIG. 1 illustrates a schematic diagram of an example system 100 in which various methods and apparatuses described herein may be implemented in accordance with aspects of the present disclosure. Referring to FIG. 1, the system 100 includes one or more client devices 101, 102, 103, 104, 105 and 106, a server 120, and one or more communication networks 110 that couple the one or more client devices to the server 120. The client devices 101, 102, 103, 104, 105, and 106 can be configured to execute one or more applications.

In aspects of the present disclosure, the server 120 can run one or more services or software applications that enable execution of a method for floating-point conversion.

In some aspects, the server 120 can also provide other services or software applications, which may include non-virtual environments and virtual environments. In some aspects, these services can be provided as web-based services or cloud services, such as to the user of the client devices 101, 102, 103, 104, 105, and/or 106 under a Software as a Service (SaaS) model.

In the configuration shown in FIG. 1, the server 120 can include one or more components that implement functions performed by the server 120. These components can include software components, hardware components, or a combination thereof that are executable by one or more processors. The user operating the client devices 101, 102, 103, 104, 105, and/or 106 can sequentially utilize one or more client applications to interact with the server 120 to utilize the services provided by these components. It should be understood that a variety of different system configurations are possible, which may be different from the system 100. Therefore, FIG. 1 is an example of a system for implementing the various methods described herein and is not intended to be limiting.

The user can use the client devices 101, 102, 103, 104, 105, and/or 106 to send data processing tasks to be performed or data to be processed. The client device can provide an interface that enables the user of the client device to interact with the client device. The client device can also output information to the user via the interface. Although FIG. 1 depicts only six client devices, those skilled in the art will be able to understand that the present disclosure can support any number of client devices.

The client devices 101, 102, 103, 104, 105, and/or 106 can include various types of computer devices, such as portable handhold devices, general-purpose computers (such as personal computers and laptop computers), workstation computers, wearable devices, smart screen devices, self-service terminal devices, service robots, gaming systems, thin clients, various message transceiving devices, sensors, or other sensing devices, and the like. These computer devices can run various types and versions of software applications and operating systems, such as Microsoft Windows, Apple iOS, Unix-like operating systems, Linux or Linux-like operating systems (e.g., Google Chrome OS); or include various mobile operating systems, such as Microsoft Windows Mobile OS, iOS, Windows Phone, Android. The portable handhold devices can include cellular telephones, smart phones, tablet computers, personal digital assistants (PDA), and the like. The wearable devices can include head-mounted displays, such as smart glasses, and other devices. The gaming systems can include various handhold gaming devices, Internet-enabled gaming devices, and the like. The client devices can perform various different applications, such as various applications related to the Internet, communication applications (e.g., e-mail applications), Short Message Service (SMS) applications, and can use various communication protocols.

The network 110 may be any type of network that is well known to those skilled in the art, which can support data communication using any of a variety of available protocols (including but not limited to TCP/IP, SNA, IPX, etc.). By way of example only, one or more networks 110 can be a local area network (LAN), an Ethernet-based network, a token ring, a wide area network (WAN), an Internet, a virtual network, a virtual private network (VPN), an intranet, an external network, a blockchain network, a public switched telephone network (PSTN), an infrared network, a wireless network (for example, Bluetooth, WiFi), and/or any combination of these and/or other networks.

The server 120 can include one or more general-purpose computers, a dedicated server computer (e.g., a PC (personal computer) server, a UNIX server, a mid-end server), a blade server, a mainframe computer, a server cluster, or any other suitable arrangement and/or combination. The server 120 may include one or more virtual machines running a virtual operating system, or other computing architectures involving virtualization (e.g., one or more flexible pools of a logical storage device that can be virtualized to maintain virtual storage devices of a server). In various aspects, the server 120 can run one or more services or software applications that provide the functions described below.

The computing unit in the server 120 can run one or more operating systems, including any of the operating systems described above and any commercially available server operating system. The server 120 can also run any of a variety of additional server applications and/or intermediate layer applications, including a HTTP server, an FTP server, a CGI server, a Java server, a database server, etc.

In some implementations, the server 120 can include one or more applications to analyze and merge data feeds and/or event updates received from the user of the client devices 101, 102, 103, 104, 105, and/or 106. The server 130 can also include one or more applications to display the data feeds and/or the real-time events via one or more display devices of the client devices 101, 102, 103, 104, 105, and/or 106.

In some aspects, the server 120 can be a server of a distributed system, or a server incorporating a block chain. The server 120 can also be a cloud server, or an intelligent cloud computing server or an intelligent cloud host with an artificial intelligence technology. The cloud server is a host product in a cloud computing service system to address the defects of difficult management and limited service scalability exiting in a traditional physical host and virtual private server (VPS) service.

The system 100 can also include one or more databases 130. In some aspects, these databases can be used to store data and other information. For example, one or more of the databases 130 can be used to store information such as audio files and video files. The databases 130 can reside in various locations. For example, the database used by the server 120 may be local to the server 120, or may be remote from the server 120 and may communicate with the server 120 via a network-based or dedicated connection. The databases 130 may be of different types. In some aspects, the database used by the server 120 can be, for example, a relational database. One or more of these databases can store, update, and retrieve data to and from the databases in response to a command.

In some aspects, one or more of the databases 130 can also be used by an application to store application data. The databases used by the application can be different types of databases, such as a key-value repository, an object repository, or a conventional repository supported by a file system.

The system 100 of FIG. 1 can be configured and operated in various ways to enable application of various methods and apparatuses described according to the present disclosure.

In the prior art, only a circuit for converting a floating-point number to an integer number is provided, however, the circuit for implementing floating-point rounding normalization that directly converts a floating-point number with higher mantissa precision to a floating-point number with lower mantissa precision is not provided.

Based on this, the present disclosure provide a method for floating-point conversion, and it is achieved that a floating-point number with higher mantissa precision is directly converted to a floating-point number with lower mantissa precision during floating-point rounding normalization without converting the floating-point number with higher mantissa precision to an integer number first and then to a floating-point number with lower mantissa precision, and it is possible to determine whether the mantissa of the floating-point number has undergone a carry overflow due to a rounding carry, thereby achieving floating-point rounding normalization accurately and efficiently..

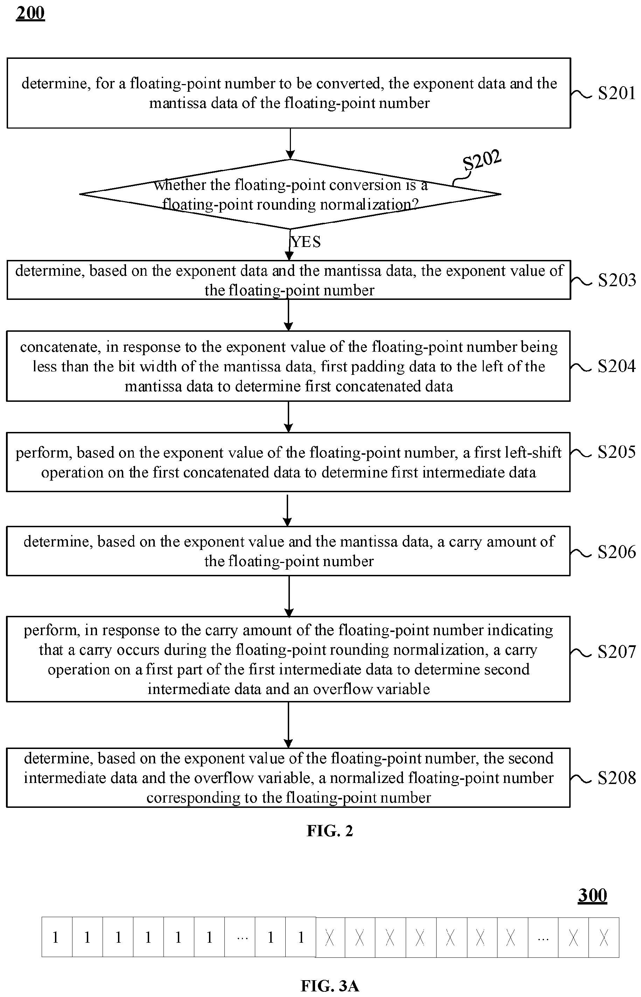

FIG. 2 illustrates a flowchart of a method 200 for floating-point conversion according to example aspects of the present disclosure. As shown in FIG. 2, the method 200 for floating-point conversion includes:

step S201, determining, for a floating-point number to be converted, the exponent data and the mantissa data of the floating-point number;

step S202, determining whether the floating-point conversion is a floating-point rounding normalization, wherein, if the determination in step S202 is "YES", proceeding to step S203;

step S203, determining, based on the exponent data and the mantissa data, the exponent value of the floating-point number, wherein the exponent value of the floating-point number is the corresponding power value of the floating-point number;

step S204, concatenating, in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data;

step S205, performing, based on the exponent value of the floating-point number, a first left-shift operation on the first concatenated data to determine first intermediate data;

step S206, determining, based on the exponent value and the mantissa data of the floating-point number, a carry amount of the floating-point number, wherein the carry amount of the floating-point number indicates whether a carry occurs during the floating-point rounding normalization;

step S207, performing, in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization; and

step S208, determining, based on the exponent value of the floating-point number, the second intermediate data and the overflow variable, a normalized floating-point number corresponding to the floating-point number.

In aspects as described in the present disclosure, it is achieved that a floating-point number with higher mantissa precision is directly converted to a floating-point number with lower mantissa precision during floating-point rounding normalization, without converting the floating-point number with higher mantissa precision to an integer number first and then to the floating-point number with lower mantissa precision; and it is possible to determine whether the mantissa of the floating-point number has undergone a carry overflow due to a rounding carry, thereby achieving floating-point rounding normalization accurately and efficiently.

According to some aspects, in step S201, the exponent data and the mantissa data of the floating-point number are determined based on the floating-point number standard and/or the floating-point number type used by the floating-point number. For example, taking a single-precision floating-point number (32-bit) as an example, and the floating-point number consists of three parts: 1 bit for the sign, 8 bits for the exponent, and 23 bits for the mantissa. Therefore, a specified number of bits of the floating-point number may be extracted to determine the exponent data and mantissa data of the floating-point number. For example, for the floating-point number "01000001001101100000000000000000", the exponent data is from the 2nd bit to the 9th bit, that is, "10000010", and the mantissa data is from the 10th bit to the 32nd bit, that is, "01000001001101100000000000000".

According to some aspects, the floating-point rounding normalization is a floating-point number conversion in which the mantissa of a floating-point number is considered as an integer and subjected to integer conversion and rounding without changing the overall representation format of the floating-point number. If the mantissa overflows when a carry occurs, the exponent of the floating-point number is adjusted accordingly, that is, the exponent value corresponding to the exponent of the floating-point number is modified by adding one.

According to some aspects, the type of floating-point rounding normalization may include round-to-positive-infinity conversion, round-to-negative-infinity conversion, round-to-zero conversion , or round-to-nearest-even conversion.

According to some aspects, in step S203, the determining the carry amount and exponent value of the floating-point number based on the exponent data and mantissa data comprises: determining the exponent value of the floating-point number based on the exponent data; and determining the carry amount of the floating-point number based on the exponent value and mantissa data of the floating-point number.

According to some aspects, the determining the exponent value of the floating-point number based on the exponent data includes: subtracting an exponent bias from the value, corresponding to the exponent data, to obtain the exponent value of the floating-point number. Taking the floating-point number "01000001001101100000000000000000" as an example, the exponent data is "10000010", the corresponding decimal data is "130 ", from which a bias 127 is subtracted to obtain a exponent value of 3.

According to some aspects, the determining the carry amount of the floating-point number based on the exponent value and mantissa data of the floating-point number comprises: determining, based on the exponent value and mantissa data of the floating-point number, the reserved bits and rounding bits corresponding to the mantissa data; and determining the carry amount of the floating-point number based on the rounding bits corresponding to the mantissa data, the lowest bit of the reserved bits and the sign data.

According to some aspects, the determining the carry amount of the floating-point number based on the rounding bits corresponding to the mantissa data, the lowest bit of the reserved bits and the sign data comprises: determining the carry amount of the floating-point number based on the rounding bits corresponding to the mantissa data, the lowest bit of the reserved bits, the sign data and the type of the rounding conversion.

According to some aspects, the method as described in the present disclosure further comprises: determining the sign data of the floating-point number, and the determining the carry amount of the floating-point number based on the exponent value and mantissa data of the floating-point number comprises: determining the carry amount of the floating-point number based on the mantissa data, the exponent value, the sign data of the floating-point number, and the type of the floating-point rounding normalization, where the floating-point rounding normalization is round-to-positive-infinity conversion, round-to-negative-infinity conversion, round-to-nearest-even conversion, or round-to-zero conversion.

For example, for the round-to-zero conversion, no carry is not generated.

For example, for the round-to-positive-infinity conversion, a carry is not generated for negative numbers, but rounding up is performed on positive numbers as long as the rounding bits of the mantissa data have a non-zero value, that is a carry is generated.

For example, for the round-to-negative-infinity conversion, a carry is not generated for positive numbers, but is generated for negative numbers when the rounding part is non-zero.

As another example, for the round-to-nearest-even conversion, if the data corresponding to the rounding bits is greater than 0.5 (the highest bit of the rounding bits is 1 and at least one subsequent bit is non-zero), a carry is performed; if the data corresponding to the rounding bits is equal to 0.5 (the highest bit of the rounding bit is 1 and all subsequent rounding bits are 0), the lowest bit of the reserved bits of the mantissa data is checked, and if the lowest bit of the reserved bits is an odd number, a carry is performed, and if the lowest bit of the reserved bits is an even number, no carry is performed; if the data corresponding to the rounding bits is less than 0.5 (the highest bit of the rounding bits is 0), no carry is performed.

According to some aspects, in step S204, in response to the exponent value of the floating-point number being less than the bit width of the mantissa data, the first padding data is concatenated to the left of the mantissa data to determine the first concatenated data, where the last bit of the first predetermined number of 1s in the first padding data is the "1" corresponding to the hidden leading bit of the mantissa data of the floating-point number, for example, in the IEEE 754 specification, the value of the floating-point number conforms to the following equation (1):

$$\text{the value of the floating-point number} = (-1)^{\text{the sign bit}} \times (1 + \text{the mantissa value}) \times 2^{\text{the exponent value}} \quad (1)$$

where the last bit 1 of the first padding data concatenated to the left of the mantissa data, as described above, corresponds to the 1 that is added to the mantissa value.

FIGS. 3A-3B illustrate a schematic diagram of a process of performing a first left-shift operation on first concatenated data according to example aspects of the present disclosure.

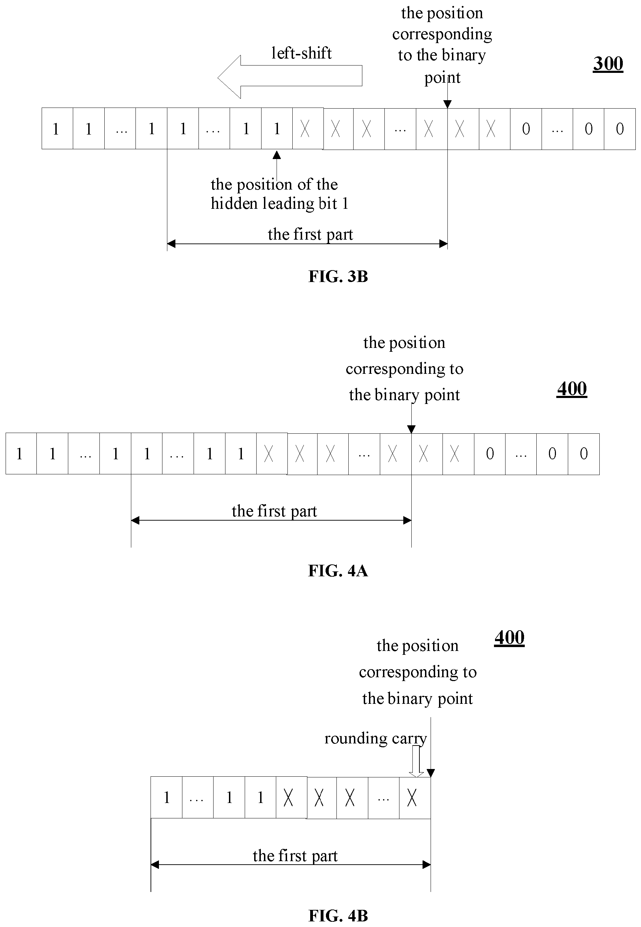

As shown in FIG. 3A, a first predetermined number of 1s is concatenated to the left of the mantissa data to form first concatenated data, where the bits represented by the symbol "X" represents the bits corresponding to the mantissa data. Moreover, as shown in FIG. 3B, the first concatenated data is left-shifted by the number of bits corresponding to the exponent value of the floating-point number to remove the partially padded 1s to obtain first intermediate data.

According to some aspects, based on whether the carry amount of the floating-point number indicates a carry occurs during the floating-point rounding normalization, a second intermediate part is determined based on the first part of the first intermediate data, where the first part of the first intermediate data is the data in the first intermediate data that corresponds to the reserved part of the first padding data and the reserved bits of the mantissa data. For example, as shown in FIG. 3B, the first part of the first intermediate data is the reserved part of the first padding data that are reserved in the first intermediate data after the first left-shift operation (in the example shown in FIG. 3B, it is the operation of left-shifting the first concatenated data by the number of bits corresponding to the exponent value of the floating-point number) and the reserved bits of the mantissa data, that is, the first part of the first intermediate data corresponds to the (the bit width of the mantissa - 1) bits that are located to the left of the position corresponding to the binary point.

In aspects as described in the present disclosure, since the concatenating and subsequent shifting operations are performed only when the exponent value of the floating-point number is less than the bit width of the mantissa data, the number of bits of the first part of the first intermediate data is the difference between the bit width of the mantissa and 1 to reduce the number of bits of the data that need to be processed subsequently. According to some aspects, the performing, in response to the carry amount of the floating-point number indicating that a carry occurs during the floating-point rounding conversion, a carry operation on the first part of the first intermediate data to determine the second intermediate data and the overflow variable comprises: performing an add-1 operation on the last bit of the first part of the first intermediate data to determine the second intermediate data; and in response to an overflow occurring when performing the add-1 operation on the last bit of the first part of the first intermediate data, setting the overflow variable to indicate that an overflow occurs when a carry occurs during the floating-point rounding normalization, and in response to no overflow occurring when performing the add-1 operation on the last bit of the first part of the first intermediate data, setting the overflow variable to indicate that no overflow occurs when a carry occurs during the floating-point rounding normalization.

According to some aspects, in response to the carry amount of the floating-point number indicating that a carry occurs during the floating-point rounding normalization, the last bit of the first part of the first intermediate data is added to 1 to perform the carry operation.

According to some aspects, the first part of the first intermediate data is truncated to determine the first part of the first intermediate data (e.g., the first part of the first intermediate data is extracted and the other parts of the first intermediate data are discarded), and a rounding carry is performed on the truncated first part of the first intermediate data to determine the second intermediate data and the overflow variable.

FIGS. 4A-4D illustrate a schematic diagram of a process of performing a carry operation on the first part of the first intermediate data according to example aspects of the present disclosure.

As shown in FIG. 4A, a first left-shift operation has been performed on the first concatenated data as described above with reference to FIG. 2 (e.g., step S205 in FIG. 2) and FIG. 3B to determine the first intermediate data, where the (the bit width of the mantissa - 1) bits of the first intermediate data that are located to the left of the position corresponding to the binary point constitute the first part.

According to some aspects, the first part of the first intermediate data is truncated to determine the first part of the first intermediate data, for example, as shown in FIG. 4B, the first part of the first intermediate data is extracted, and the other parts of the first intermediate data are discarded.

According to some aspects, the last bit of the first part of the first intermediate data is added to 1, that is, as shown in FIG. 4B, a rounding carry operation is performed on the last bit of the first part of the first intermediate data.

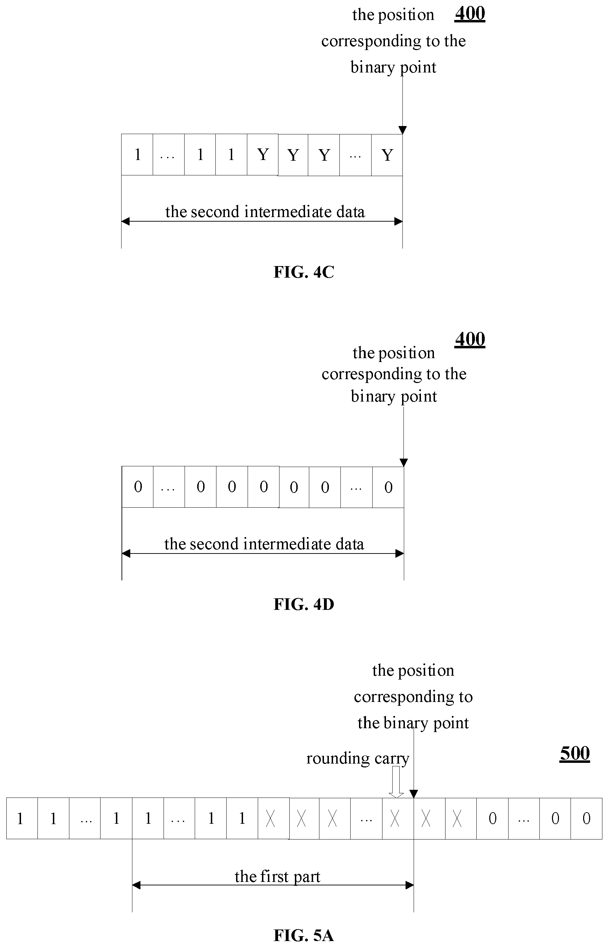

According to some aspects, as shown in FIG. 4C, when no overflow occurs when the first part of the first intermediate data is incremented by 1, the sum of the last bit of the first part of the first intermediate data and 1 is the second intermediate data, and the overflow variable is set to indicate that no overflow occurs when a carry occurs during the floating-point rounding normalization.

According to some aspects, as shown in FIG. 4D, when an overflow occurs when the first part of the first intermediate data is incremented by 1, all bits of the second intermediate data are 0, and the overflow variable is set to indicate that an overflow occurs when a carry occurs during the floating-point rounding normalization.

According to some aspects, a rounding carry operation is performed on the first part of the first intermediate data to determine the carried data and the overflow variable, and the first part of the carried data is truncated to determine second intermediate data, where the first part of the carried data is the bits in the carried data corresponding to the first part of the first intermediate data, that is, the (the bit width of the mantissa - 1) bits in the carried data that are located to the left of and started from the bit corresponding to the last bit of the mantissa data (including the bit corresponding to the last bit of the mantissa data).

FIGS. 5A-5E illustrate a schematic diagram of a process of performing a carry operation on the first part of the first intermediate data according to example aspects of the present disclosure.

As shown in FIG. 5A, the first left-shift operation has been performed on the first concatenated data as described above with reference to FIG. 2 (e.g., step S205 in FIG. 2) and FIG. 3B to determine the first intermediate data, where the (the bit width of the mantissa - 1) bits of the first intermediate data that are located to the left of the position corresponding to the binary point constitute the first part.

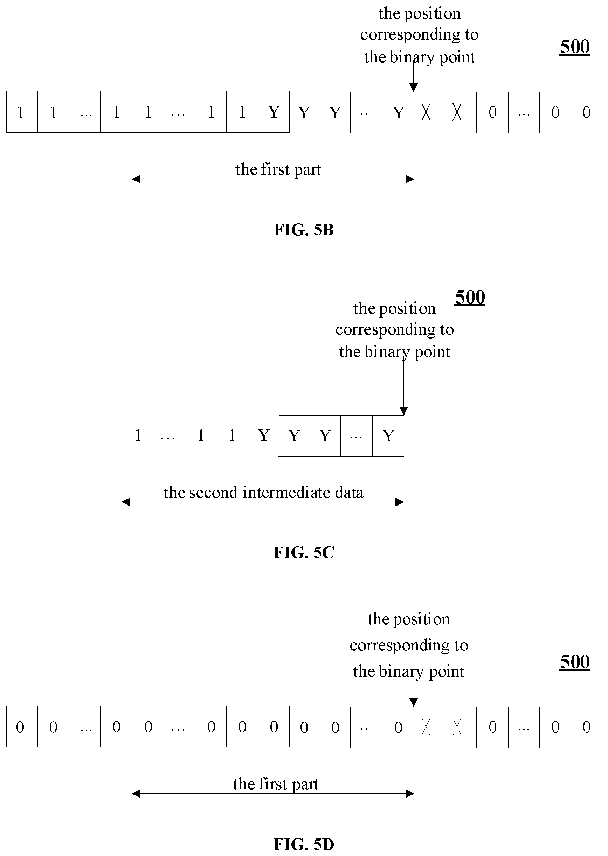

According to some aspects, as shown in FIG. 5B, when no overflow occurs when the last bit of the first part of the first intermediate data is incremented by 1, the overflow variable is set to indicate that no overflow occurs when a carry occurs during the floating-point rounding normalization, and the part of the carried data corresponding to the mantissa data is the data after taking into account the effect of the rounding carry (i.e., the bits represented by the symbol "Y" in FIG. 5B represent the part corresponding to the mantissa data).

According to some aspects, as shown in FIG. 5C, the first part of the carried data is truncated to determine the second intermediate data, where the second intermediate data is the bits in the carried data corresponding to the first part of the first intermediate data, that is, the (the bit width of the mantissa - 1) bits in the carried data that are located to the left of and started from the bit corresponding to the last bit of the mantissa data (including the bit corresponding to the last bit of the mantissa data).

According to some aspects, as shown in FIG. 5D, when an overflow occurs when the last bit of the first part of the first intermediate is incremented by 1, the overflow variable is set to indicate that an overflow occurs when a carry occurs during the floating-point rounding normalization, and all bits of the carried data that are located to the left of the position corresponding to the binary point (i.e., the bit of the carried data corresponding to the last bit of the mantissa data, and the bits located to the left of this bit ) are 0.

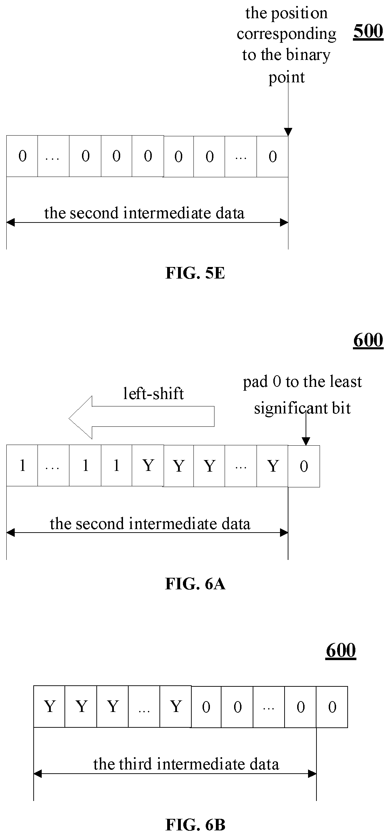

According to some aspects, as shown in FIG. 5E, the first part of the carried data is truncated to determine the second intermediate data, where the second intermediate data is the bits in the carried data corresponding to the first part of the first intermediate data, that is, the (the bit width of the mantissa - 1) bits in the carried data that are located to the left of and started from the bit corresponding to the last bit of the mantissa data (including the bit corresponding to the last bit of the mantissa data). According to other aspects, since it is illustrated in FIG. 5D that an overflow occurs when the last bit of the first part of the first intermediate data is incremented by 1, it is also possible to directly set all bits of the second intermediate data to 0 instead of performing the truncation as illustrated in FIG. 5E.

According to some aspects, the performing, in response to the carry amount of the floating-point number indicating that a carry occurs during the floating-point rounding conversion, a carry operation on the first part of the first intermediate data to determine the second intermediate data and the overflow variable further comprises: in response to all bits of the first part of the first intermediate data being 1, setting the overflow variable to indicate that an overflow occurs when a carry occurs during the floating-point rounding normalization, and setting the second intermediate data to all 0; and in response to not all bits of the first part of the first intermediate data being 1, setting the overflow variable to indicate that no overflow occurs when a carry occurs during the floating-point rounding normalization, and performing an add-1 operation on the last bit of the first part of the first intermediate data to determine the second intermediate data.

According to some aspects, when not all bits of the first part of the first intermediate data are 1, the process of performing an add-1 operation on the last bit of the first part of the first intermediate data to determine the second intermediate data is similar to the process described above with reference to FIGS. 4A-4D or 5A-5E. That is, the first part may be first truncated from the first intermediate data, and then an add-1 operation is performed on the last bit of the first part, or the add-1 operation may be first performed on the last bit of the first intermediate data and then truncate the first part to determine the second intermediate data.

In aspects as described in the present disclosure, it is determined whether an overflow occurs when a carry occurs during the floating-point number carry normalization by determining whether all bits of the first part of the first intermediate data are 1. According to some embodiments, the determining the normalized floating-point number corresponding to the floating-point number based on the exponent value of the floating-point number, the second intermediate data and the overflow variable comprises: performing, based on the exponent value of the floating-point number, a second left-shift operation on the second intermediate data to determine a third intermediate data; concatenating a 0 to the right of the third intermediate data to determine the mantissa data of the normalized floating-point number; and determining the exponent data of the normalized floating-point number based on the exponent value of the floating-point number and the overflow variable.

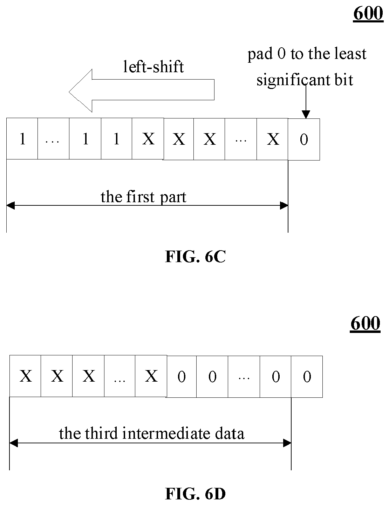

FIGS. 6A-6B illustrate a schematic diagram of a process 600 for determining the mantissa data of a normalized floating-point number when the carry amount of the floating-point number indicates that a carry occurs during the floating-point rounding normalization according to example aspects of the present disclosure.

According to some aspects, as shown in FIGS. 6A-6B, the second intermediate data is left-shifted to remove the bits corresponding to the first padding data, for example, the second intermediate data is left-shifted by (the bit width of the mantissa - the exponent value - 1) bits, where the bits represented by the symbol "Y" represent the bits in the second intermediate data corresponding to the mantissa data, for example, the bits in the second intermediate data represented by the symbol "Y" in FIGS. 4C and 5C which correspond to the mantissa data.

According to some aspects, a 0 is concatenated to the right of the third intermediate data to extend the data with a bit-width of (the bit width of the mantissa - 1) to a data with a bit-width of the bit-width of the mantissa, that is, the mantissa data of the normalized floating-point number.

According to some aspects, it is possible to omit the above process of performing the second left-shift operation on the second intermediate data to determine the third intermediate data when the overflow variable indicates that an overflow occurs, and instead directly set all bits of the third intermediate data to 0. Moreover, a 0 is concatenated to the right of the third intermediate data to obtain the mantissa data of the normalized floating-point number, that is, a number of 0s corresponding to the bit width of the mantissa.

According to some aspects, the determining the exponent data of the normalized floating-point number based on the exponent value of the floating-point number and the overflow variable comprises: setting, in response to the overflow variable of the floating-point number indicating that an overflow occurs when a carry occurs during the floating-point normalization, the exponent data of the normalized floating-point number to indicate that the exponent value of this normalized floating-point number is the sum of the exponent value of the original floating-point number plus 1; and setting, in response to the overflow variable of the floating-point number indicating that no overflow occurs when a carry occurs during the floating-point normalization, the exponent data of the normalized floating-point number to indicate that the exponent value of this normalized floating-point number is the exponent value of the original floating-point number.

According to some aspects, the exponent data of the normalized floating-point number may be set to the sum of the exponent value of the normalized floating-point number and an exponent bias.

According to some aspects, the method as described in the present disclosure further comprises, in response to the floating-point conversion being a floating-point rounding normalization, performing: performing, in response to the carry amount of the floating-point number indicating that no carry occurs during the floating-point rounding normalization, a second left-shift operation on the first part of the first intermediate data based on the exponent value of the floating-point number to determine fourth intermediate data; concatenating a 0 to the right of the fourth intermediate data to determine the mantissa data of the normalized floating-point number; and determining, based on the exponent value of the floating-point number, the exponent data of the normalized floating-point number.

FIGS. 6C-6D illustrate a schematic diagram of the process 600 for determining the mantissa data of the normalized floating-point number when the carry amount of the floating-point number indicates that no carry occurs during the floating-point rounding normalization according to example aspects of the present disclosure.

According to some aspects, the first part of the first intermediate data is truncated from the first intermediate data, for example, as described above with reference to FIG. 4B, the first part of the first intermediate data is extracted and other parts of the first intermediate data are discarded.

According to some aspects, as shown in FIGS. 6C-6D, the first part of the first intermediate data is left-shifted to remove the bits corresponding to the first padding data to obtain the third intermediate data, for example, the first part of the first intermediate data is left-shifted by (the bit width of the mantissa - exponent value -1) bits, wherein the bits represented by the symbol "X" represent the bits in the first part corresponding to the mantissa data.

According to some aspects, a 0 is concatenated to the right of the third intermediate data to extend the data with a bit-width of (the bit width of the mantissa - 1) to a data with a bit-width of the bit-width of the mantissa, that is, the mantissa data of the normalized floating-point number.

According to some aspects, the determining the exponent data of the normalized floating-point number based on the exponent value of the floating-point number includes: setting the exponent data of the normalized floating-point number to indicate that the exponent value of this normalized floating-point number is the exponent value of the original floating-point number.

According to some aspects, the exponent data of the normalized floating-point number may be set to the exponent value of the normalized floating-point number plus an exponent bias.

According to some aspects, the method as described in the present disclosure further performs, in response to the floating-point conversion being a floating-point rounding normalization: in response to the exponent value of the floating-point number being greater than or equal to the bit width of the mantissa data, setting the normalized floating-point number, corresponding to the floating-point number, to the floating-point number to be converted.

According to some aspects, the method as described in the present disclosure further comprises: performing, in response to the floating-point conversion being a floating-point integer conversion: determining, based on the exponent data and the mantissa data, the carry amount and the exponent value of the floating-point number; concatenating, in response to the exponent value of the floating-point number being less than the output bit width of the floating-point integer conversion, second padding data to the left of the mantissa data to determine second concatenated data, wherein the second padding data comprises a second predetermined number of 0s and a 1, wherein the second predetermined number is equal to the difference between the integer width of the floating-point conversion and 1; performing, based on the exponent value of the floating-point number, a third left-shift operation on the second concatenated data to determine fifth intermediate data; and determining, based on the carry amount of the floating-point number and the fifth intermediate data, a rounded integer number of the floating-point number.

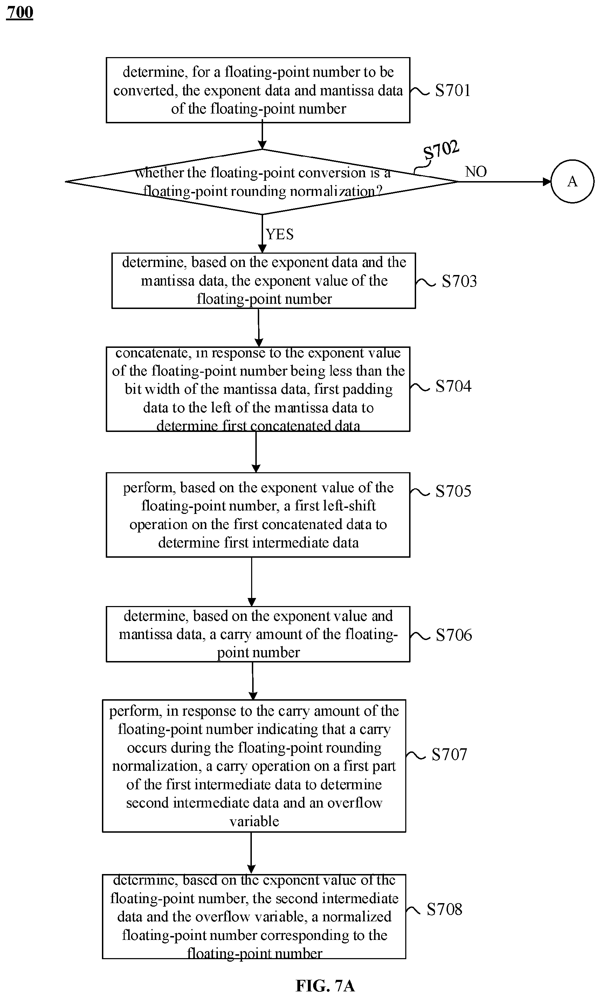

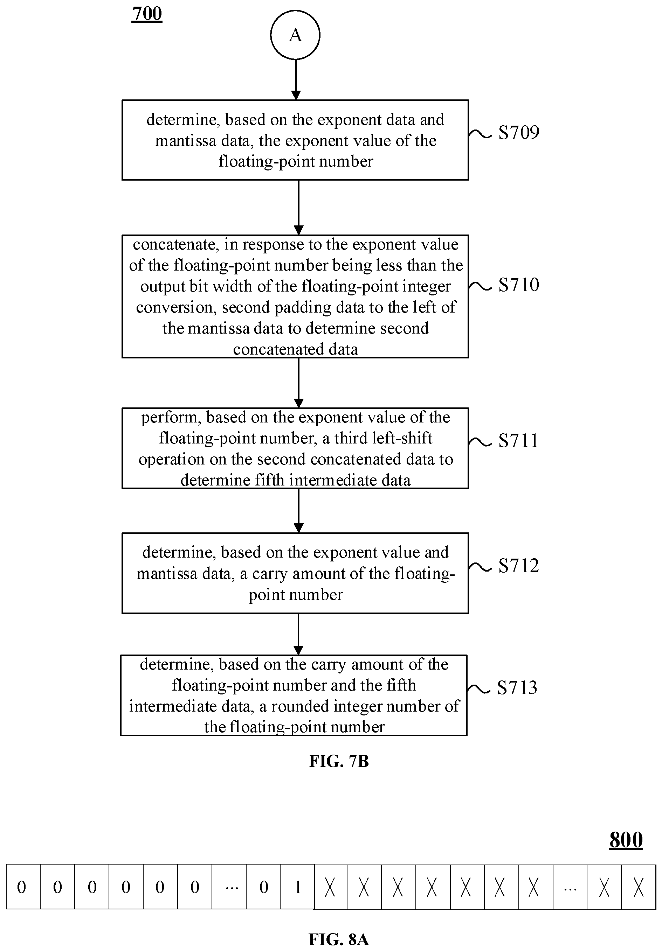

FIGS. 7A-7B illustrate a flowchart of a method 700 for floating-point conversion according to example aspects of the present disclosure. As shown in FIGS. 7A-7B, the method 700 comprises:

step S701, determining, for a floating-point number to be converted, the exponent data and mantissa data of the floating-point number;

step S702, determining whether the floating-point conversion is a floating-point rounding normalization, wherein, if the determination result of step S702 is "YES", proceeding to step S703, and, if the determination result of step S702 is "NO", proceeding to step S709;

step S703: determining, based on the exponent data and the mantissa data, the exponent value of the floating-point number, wherein the exponent value of the floating-point number is the corresponding power value of the floating-point number;

step S704, concatenating, in response to the exponent value of the floating-point number being less than the bit width of the mantissa data, first padding data to the left of the mantissa data to determine first concatenated data, wherein the first padding data comprises a first predetermined number of 1s, and the first predetermined number is greater than or equal to the bit width of the mantissa data;

step S705, performing, based on the exponent value of the floating-point number, a first left-shift operation on the first concatenated data to determine first intermediate data;

step S706, determining, based on the exponent value and mantissa data of the floating-point number, a carry amount of the floating-point number, wherein the carry amount of the floating-point number indicates whether or not a carry occurs during the floating-point rounding normalization;

step S707, performing, in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization;

step S708, determining, based on the exponent value of the floating-point number, the second intermediate data and the overflow variable, a normalized floating-point number corresponding to the floating-point number;

step S709, determining, based on the exponent data and mantissa data, the exponent value of the floating-point number;

step S710, concatenating, in response to the exponent value of the floating-point number being less than the output bit width of the floating-point integer conversion, second padding data to the left of the mantissa data to determine second concatenated data, wherein the second padding data includes a second predetermined number of 0s and a 1, and the second predetermined number is equal to the difference between the bit width of the integer number of the floating-point conversion and 1;

step S711, performing, based on the exponent value of the floating-point number, a third left-shift operation on the second concatenated data to determine fifth intermediate data;

step S712, determining, based on the exponent value and mantissa data of the floating-point number, a carry amount of the floating-point number; and

step S713, determining, based on the carry amount of the floating-point number and the fifth intermediate data, a rounded integer number of the floating-point number.

According to some aspects, steps S701 to 708 are the same as or similar to the steps S201 to 208, respectively.

According to some embodiments, after determining the exponent data and mantissa data of the floating-point number (i.e., at step S201 in FIG. 2 or step S701 in FIG. 7A), the floating-point number in special cases are handled accordingly without requiring subsequent processing.

According to some aspects, in response to the floating-point conversion being a floating-point integer conversion, the output type is unsigned integer, and if the sign data of the floating-point number to be converted is 1, the converted integer number is set to 0, as this indicates that the floating-point number to be converted is a negative number.

According to some aspects, in response to all bits of the exponent data of the floating-point number to be converted being 1 and the mantissa data of the floating-point number to be converted not being all 0, the floating-point number to be converted is of a Not a Number (NaN) type, wherein if the floating-point conversion is a floating-point rounding normalization, the normalized floating-point number may be configured in a NaN output format, and if the floating-point conversion is a floating-point integer conversion, the converted integer number may be set to 0.

According to some aspects, in response to the exponent value of the floating-point number to be converted being greater than or equal to the output bit width, or the exponent value of the floating-point number to be converted being equal to (output bit width - 1) and the floating-point number to be converted being a signed number, wherein if the floating-point conversion is a floating-point rounding normalization, the normalized floating-point number may be set to the floating-point number to be converted, and if the floating-point conversion is a floating-point integer conversion, the converted integer number is set to the maximum or minimum value of the corresponding type based on the sign bit. According to some aspects, when the floating-point number to be converted is of infinity type, if the floating-point number to be converted is an unsigned number, the converted integer number is set to the maximum value of the unsigned number, if the floating-point number to be converted is a signed number and the sign data is 1, the converted integer number is set to the minimum value of the signed number (i.e., with the highest bit being 1 and all the remaining bits being 0), and if the floating-point number to be converted is a signed number and the sign data is 0, the converted integer number is set to the maximum value of the signed number (i.e., with the highest bit being 0 and all the remaining bits being 1).

According to some aspects, when the above overflow occurs during the floating-point conversion, if the floating-point conversion is a floating-point rounding normalization, the normalized floating-point number can be set to the floating-point number to be converted, and, if the floating-point conversion is a floating-point integer conversion, the converted integer number is set to the corresponding floating-point type based on the sign bit. According to some aspects, when the above overflow occurs during the floating-point conversion, if the floating-point number to be converted is an unsigned number, the converted integer number is set to the maximum value of the unsigned number, if the floating-point number to be converted is a signed number and the sign data is 1, the converted integer number is set to the minimum value of the signed number (i.e., with the highest bit being 1 and all the remaining bits being 0) and, if the floating-point number to be converted is a signed number and the sign data is 0, the converted integer number is set to the maximum value of the signed number (i.e., with the highest bit being 0 and all the remaining bits being 1).

According to some aspects, in response to all bits of the exponent data of the floating-point number to be converted being 0 and all bits of the converted data being 0, the floating-point number to be converted corresponds to 0. According to some aspects, when the floating-point number to be converted corresponds to 0, if the floating-point conversion is a floating-point integer conversion, all bits of the converted integer number are set to 0. According to some aspects, when the floating-point conversion is a floating-point rounding normalization, the normalized floating-point number corresponding to the floating-point number is set to the floating-point number to be converted.

According to some aspects, if all bits of the exponent data of the floating-point number to be converted are 0 and not all bits of the mantissa data of the floating-point number to be converted are 0, or if the exponent value of the floating-point number to be converted is less than -1, an underflow determination is performed, and the value corresponding to the conversion is set based on the result of the underflow determination. According to some aspects, when the above conditions for performing the underflow determination are met, the underflow determination is: when the sign data of the floating-point number to be converted is 0 and the rounding type is not the round-to-positive-infinity conversion, or when the sign data of the floating-point number to be converted is 1 and the rounding type is not the round-to-negative-infinity conversion, it is determined that an underflow occurs; otherwise, it is determined that no underflow occurs.

According to some aspects, when it is determined that an underflow occurs, if the floating-point conversion is a floating-point rounding normalization and the sign data of the floating-point number to be converted is 1, the sign data of the normalized floating-point number is set to 1 and the exponent data and mantissa data of the normalized floating-point number are set to 0, and if the floating-point conversion is a floating-point rounding normalization and the sign data of the floating-point number to be converted is 0, the sign data of the normalized floating-point number is set to 0 and the exponent data and mantissa data of the normalized floating-point number are set to 0, and if the floating-point conversion is a floating-point integer conversion, the converted integer number is set to all 0.

According to some aspects, when it is determined that no underflow occurs, if the floating-point conversion is a floating-point rounding normalization and the sign data of the floating-point number to be converted is 1, the sign data of the normalized floating-point number is set to 1, the exponent data of the normalized floating-point number is set with the highest bit being 0 and all other bits being 1, all bits of the mantissa data of the normalized floating-point number are set to 0, and if the floating-point conversion is a floating-point rounding normalization and the sign data of the floating-point number to be converted is 0, the sign data of the normalized floating-point number is set to 0, the exponent data of the normalized floating-point number is set with the highest bit being 0 and all other bits being 1, and all bits of the mantissa data of the normalized floating-point number are set to 0. According to some aspects, when it is determined that no underflow occurs, if the floating-point conversion is a floating-point integer conversion and the sign data of the floating-point number to be converted is 1, the sign data of the converted integer number is set to 1 and all other bits of the converted integer number are set to 1, and if the floating-point conversion is a floating-point integer conversion and the sign data of the floating-point number to be converted is 0, the lowest bit of the converted integer number is set to 1 and all other bits of the converted integer number are set to 0.

According to some aspects, if the exponent value of the floating-point number to be converted is (-1), it is determined whether a carry occurs for the floating-point number to be converted during the floating-point conversion. According to some aspects, if the exponent value of the floating-point number to be converted is (-1) and it is determined that a carry occurs for the floating-point number to be converted during the floating-point conversion, the output of the floating-point conversion is set based on the sign data of the floating-point number to be converted, wherein if the sign bit of the floating-point number to be converted is 1, the normalized floating-point number or the converted integer number is set to a value corresponding to (-1), and if the sign bit of the floating-point number to be converted is 0, the normalized floating-point number or the converted integer number is set to a value corresponding to 1.

According to some aspects, if the exponent value of the floating-point number to be converted is (-1) and it is determined that no carry occurs for the floating-point number to be converted during the floating-point conversion, for the floating-point rounding normalization, the sign data of the normalized floating-point number is set to be the same as the sign data of the floating-point number to be converted, and the exponent data and mantissa data of the normalized floating-point number are both set to 0, and for the floating-point integer conversion, the converted integer number is set to a value corresponding to 0, for example, all bits of the converted integer number are set to 0.

FIGS. 8A-8B illustrate a schematic diagram of a process for performing a third left-shift operation on the second concatenated data according to example aspects of the present disclosure.

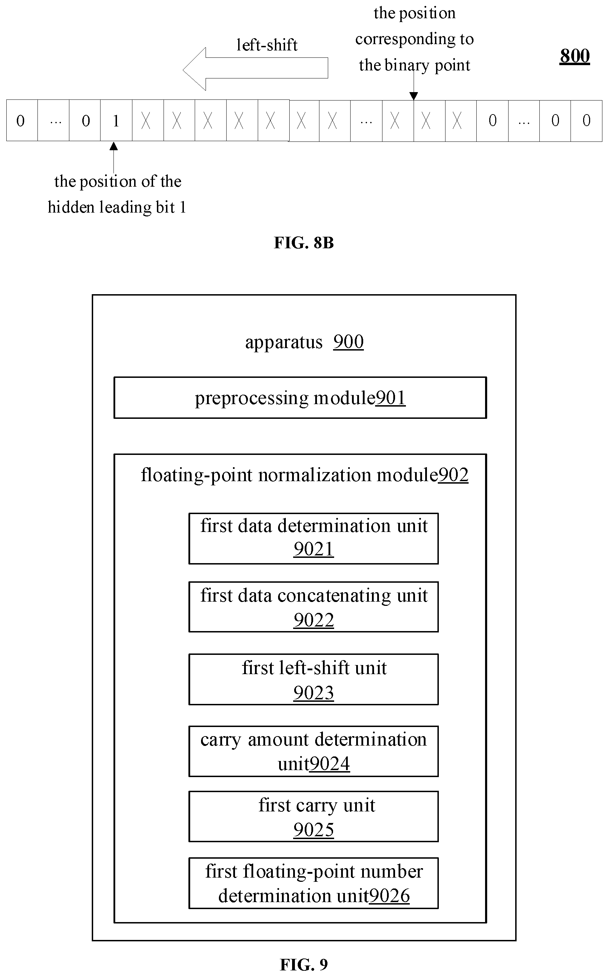

As shown in FIG. 8A, a second predetermined number of 0s and a 1 are concatenated to the left of the mantissa number data to form the second concatenated data, wherein the bits represented by the symbol "X" represents the bits corresponding to the mantissa data. Moreover, as shown in FIG. 8B, the second concatenated data is left-shifted by the number of bits corresponding to the exponent value of the floating-point number to determine the shift-rounded integer bits, that is, to determine the shift-rounded integer bits based on the corresponding part between the position of the hidden predecessor 1 and the position corresponding to the binary point.

According to some aspects, the first predetermined number is equal to the integer width of the floating-point conversion, and the first left-shift operation and the third left-shift operation are performed by the same shifter. In aspects as described in the present disclosure, by using the same shifter in the first left-shift operation and third left-shift operation, it is possible to multiplex the same circuit resources in different rounding conversions to save the circuit overhead.

According to another aspect of the present disclosure, there is provided a apparatus for testing a cache. FIG. 9 illustrates a structural block diagram of a apparatus 900 for testing a cache according to example aspects of the present disclosure, wherein the cache is used to cache data stored in a main memory. As shown in FIG. 9, the apparatus 900 comprises: a preprocessing module 901 configured to: determine, for a floating-point number to be converted, the exponent data and mantissa data of the floating-point number; and a floating-point normalization module 902, comprising: a first data determination unit 9021 configured to: determine, based on the exponent data and the mantissa data, the exponent value of the floating-point number, wherein the exponent value of the floating-point number is the corresponding power value of the floating-point number; a first data concatenating unit 9022 configured to :concatenate, in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data; a first left-shift unit 9023 configured to: perform, based on the exponent value of the floating-point number, a first left-shift operation on the first concatenated data to determine first intermediate data; a carry amount determination unit 9024 configured to: determine, based on the exponent value and mantissa data of the floating-point number, a the carry amount of the floating-point number, wherein the carry amount of the floating-point number indicates whether a carry occurs during the floating-point rounding normalization; a first carry unit 9025 configured to: perform, in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization; and a first floating-point number determination unit 9026 configured to: determine, based on the exponent value of the floating-point number, the second intermediate data and the overflow variable, a normalized floating-point number corresponding to the floating-point number.

According to some aspects, the first carry unit 9025 includes: an addition sub-unit configured to: perform an add-1 operation on the last bit of the first part of the first intermediate data to determine the second intermediate data; and an overflow setting sub-unit configured to: set, in response to an overflow occurring when performing the add-1 operation on the last bit of the first part of the first intermediate data, the overflow variable to indicate that an overflow occurs when a carry occurs during the floating-point rounding normalization, and set, in response to no overflow occurring when performing the add-1 operation on the last bit of the first part of the first intermediate data, the overflow variable to indicate that no overflow occurs when a carry occurs during the floating-point rounding normalization.

According to some aspects, the first carry unit 9025 includes: an overflow setting sub-unit configured to: in response to all bits of the first part of the first intermediate data being 1, set the overflow variable to indicate that an overflow occurs when a carry occurs during the floating-point rounding normalization, and set the second intermediate data to all 0; and an addition sub-unit configured to: in response to the bits of the first part of the first intermediate data not all being 1, set the overflow variable to indicate that no overflow occurs when a carry occurs during the floating-point rounding normalization, and perform an add-1 operation on the last bit of the first part of the first intermediate data to determine the second intermediate data.

According to some aspects, the first floating-point number determination unit 9026 includes: a second left-shift sub-unit configured to: perform, based on the exponent value of the floating-point number, a second left-shift operation on the second intermediate data to determine third intermediate data; a mantissa determination sub-unit configured to: concatenate a 0 to the right of the third intermediate data to determine the mantissa data of the normalized floating-point number; and an exponent determination sub-unit configured to: determine, based on the exponent value of the floating-point number and the overflow variable, the exponent data of the normalized floating-point number.

According to some aspects, the floating-point normalization module 902 further includes: a none carry unit configured to: in response to the carry amount of the floating-point number indicating that no carry occurs during the floating-point rounding normalization, perform a second left-shift operation on the first part of the first intermediate data based on the exponent value of the floating-point number to determine the mantissa data of the normalized floating-point number, and determine the exponent data of the normalized floating-point number based on the exponent value of the floating-point number.

According to some aspects, the floating-point normalization module 902 further includes: a second floating-point number determination unit configured to: set, in response to the exponent value of the floating-point number being greater than or equal to the bit width of the mantissa data, the normalized floating-point number corresponding to the floating-point number to the floating-point number to be converted.

According to some aspects, the preprocessing module 901 is further configured to: determine the sign data of the floating-point number, and the carry amount determination unit 9024 includes: a carry amount determination sub-unit configured to: determine, based on the mantissa data, the exponent value, the sign data of the floating-point number and the type of the floating-point rounding normalization, the carry amount of the floating-point number, where the type of the floating-point rounding normalization is round-to-positive-infinity conversion, round-to-negative-infinity conversion, round-to-nearest-even conversion, or round-to-zero conversion.

According to some aspects, the apparatus 900 further includes a floating-point integer conversion module, and the floating-point integer conversion module includes: a second data determination unit configured to: determine, based on the exponent data and mantissa data, the carry amount and exponent value of the floating-point number; a second data concatenating unit configured to: concatenate, in response to the exponent value of the floating-point number being less than the output bit width of the floating-point integer conversion, second padding data to the left of the mantissa data to determine second concatenated data, wherein the second padding data includes a second predetermined number of 0s and a 1, wherein the second predetermined number is equal to the difference between the integer width of the floating-point conversion and 1; a third left-shift unit configured to: perform, based on the exponent value of the floating-point number, a third left-shift operation on the second concatenated data to determine fifth intermediate data; and a second integer number determination unit configured to: determine, based on the carry amount of the floating-point number and the fifth intermediate data, a rounded integer number of the floating-point number.

According to some aspects, the first predetermined number is equal to the integer width of the floating-point conversion, and the first left-shift operation and the third left-shift operation are performed by the same shifter.

According to one aspect of the present disclosure, there is also provided a chip, including the apparatus 900 for floating-point conversion as described above.

According to one aspect of the present disclosure, there is provided an electronic device, comprising: at least one processor; and a memory communicatively connected to the at least one processor; wherein the memory stores instructions executable by the at least one processor, and the instructions are executed by the at least one processor to enable the at least one processor to perform the above method for floating-point conversion.

According to one aspect of the present disclosure, there is provided a non-transient computer-readable storage medium storing computer instructions, wherein the computer instructions are used to enable the computer to perform the above method for floating-point conversion.

According to one aspect of the present disclosure, there is provided a computer program product, including an computer program, wherein the computer program implements the above method for floating-point conversion when executed by a processor.

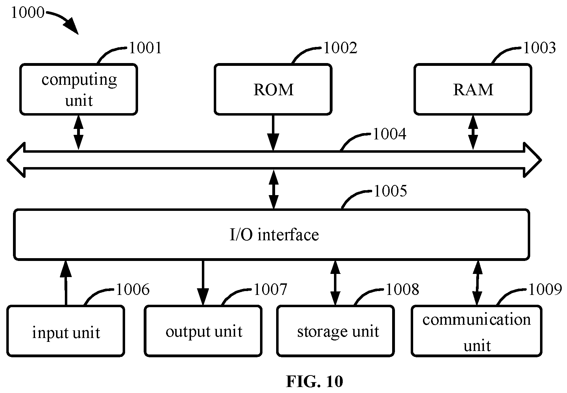

Referring to FIG. 10, a structural block diagram of an electronic device 1000 that may be a server or client of the present disclosure is now described, which is an example of a hardware device that may be applicable to aspects of the present disclosure. Electronic devices are intended to represent various forms of digital electronic computer devices, such as laptop computers, desktop computers, workstations, personal digital assistants, servers, blade servers, mainframe computers, and other suitable computers. The electronic devices may also represent various forms of mobile devices, such as personal digital processing, cellular telephones, smart phones, wearable devices, and other similar computing devices. The components shown herein, their connections and relationships, and their functions are merely as examples, and are not intended to limit the implementations of the disclosure described and/or claimed herein.

As shown in FIG. 10, the electronic device 1000 includes a computing unit 1001, which may perform various appropriate actions and processing according to a computer program stored in a read-only memory (ROM) 1002 or a computer program loaded into a random access memory (RAM) 1003 from a storage unit 1008. In the RAM 1003, various programs and data required by the operation of the electronic device 1000 may also be stored. The computing unit 1001, the ROM 1002, and the RAM 1003 are connected to each other through a bus 1004. Input/output (I/O) interface 1005 is also connected to the bus 1004.

A plurality of components in the electronic device 1000 are connected to a I/O interface 1005, including: an input unit 1006, an output unit 1007, a storage unit 1008, and a communication unit 1009. The input unit 1006 may be any type of device capable of inputting information to the electronic device 1000, the input unit 1006 may receive input digital or character information and generate a key signal input related to user setting and/or function control of the electronic device, and may include, but is not limited to, a mouse, a keyboard, a touch screen, a track pad, a trackball, a joystick, a microphone, and/or a remote control. The output unit 1007 may be any type of device capable of presenting information, and may include, but are not limited to, a display, a speaker, a video/audio output terminal, a vibrator, and/or a printer. The storage unit 1008 may include, but is not limited to, a magnetic disk and an optical disk. The communication unit 1009 allows the electronic device 1000 to exchange information/data with other devices over a computer network, such as the Internet, and/or various telecommunication networks, and may include, but is not limited to, a modem, a network card, an infrared communication device, a wireless communication transceiver and/or a chipset, such as a Bluetooth device, a 802.11 device, a WiFi device, a WiMAX device, a cellular communication device, and/or the like.

The computing unit 1001 may be a variety of general and/or special purpose processing components with processing and computing capabilities. Some examples of the computing unit 1001 include, but are not limited to, a central processing unit (CPU), a graphic processing unit (GPU), various dedicated artificial intelligence (AI) computing chips, various computing units running machine learning model algorithms, a digital signal processor (DSP), and any suitable processor, controller, microcontroller, etc. The computing unit 1001 performs the various methods and processes described above, for example, the data process method. For example, in some aspects, the data process method may be implemented as a computer software program tangibly contained in a machine-readable medium, such as the storage unit 1008. In some aspects, part or all of the computer program may be loaded and/or installed onto the electronic device 1000 via the ROM 1002 and/or the communication unit 1009. When the computer program is loaded to the RAM 1003 and executed by the computing unit 1001, one or more steps of the data process method described above may be performed. Alternatively, in other aspects, the computing unit 1001 may be configured to perform the data process method by any other suitable means (e.g., with the aid of firmware).

Various aspects of the systems and techniques described above herein may be implemented in a digital electronic circuit system, an integrated circuit system, a field programmable gate array (FPGA), an application specific integrated circuit (ASIC), a dedicated standard product (ASSP), a system of system on a chip system (SoC), a complex programmable logic device (CPLD), computer hardware, firmware, software, and/or combinations thereof. These various aspects may include: implementation in one or more computer programs that may be executed and/or interpreted on a programmable system including at least one programmable processor, where the programmable processor may be a dedicated or universal programmable processor that may receive data and instructions from a storage system, at least one input device, and at least one output device, and transmit data and instructions to the storage system, the at least one input device, and the at least one output device.

The program code for implementing the method of the present disclosure may be written in any combination of one or more programming languages. These program code may be provided to a processor or controller of a general-purpose computer, a special purpose computer, or other programmable data processing device such that the program code, when executed by the processor or controller, causes the functions/operations specified in the flowchart and/or block diagram to be implemented. The program code may be executed entirely on the machine, partly on the machine, partly on the machine as a stand-alone software package and partly on the remote machine or entirely on the remote machine or server.

In the context of the present disclosure, a machine-readable medium may be a tangible medium, which may contain or store a program for use by or in conjunction with an instruction execution system, apparatus, or device. The machine-readable medium may be a machine-readable signal medium or a machine-readable storage medium. The machine-readable medium may include, but is not limited to, electronic, magnetic, optical, electromagnetic, infrared, or semiconductor systems, apparatus, or devices, or any suitable combination of the foregoing. More specific examples of a machine-readable storage media may include an electrical connection based on one or more wires, a portable computer disk, a hard disk, a random access memory (RAM), a read-only memory (ROM), an erasable programmable read-only memory (EPROM or flash memory), an optical fiber, a portable compact disk read-only memory (CD-ROM), an optical storage device, a magnetic storage device, or any suitable combination of the foregoing.

To provide interaction with a user, the systems and techniques described herein may be implemented on a computer having: a display device (e.g., a CRT (cathode ray tube) or an LCD (liquid crystal display) monitor) for displaying information to a user; and a keyboard and pointing device (e.g., a mouse or trackball) by which a user may provide input to the computer. Other types of devices may also be used to provide interaction with a user; for example, the feedback provided to the user may be any form of perception feedback (e.g., visual feedback, auditory feedback, or tactile feedback); and the input from the user may be received in any form, including acoustic input, voice input, or haptic input.

The systems and techniques described herein may be implemented in a computing system including a back-end component(e.g., as a data server), or a computing system including a middleware component (e.g., an application server), or a computing system including a front-end component (e.g., a user computer with a graphic user interface or a web browser, the user may interact with implementations of the systems and techniques described herein through the graphic user interface or the web browser), or in a computing system including any combination of such back-end components, middleware components, or front-end components. The components of the system may be interconnected by digital data communication (e.g., a communications network) in any form or medium. Examples of communication networks include a local area network (LAN), a wide area network (WAN), the Internet, and a blockchain network.

The computer system may include a client and a server. Clients and servers are generally remote from each other and typically interact through a communication network. The relationship between clients and servers is generated by computer programs running on respective computers and having a client-server relationship to each other. The server may be a cloud server, or may be a server of a distributed system, or a server incorporating a block chain.

It should be understood that the various forms of processes shown above may be used, and the steps may be reordered, added, or deleted. For example, the steps described in the present disclosure may be performed in parallel or sequentially or in a different order, as long as the results expected by the technical solutions disclosed in the present disclosure can be achieved, and no limitation is made herein.

Although aspects or examples of the present disclosure have been described with reference to the accompanying drawings, it should be understood that the foregoing methods, systems, and devices are merely aspects or examples, and the scope of the present disclosure is not limited by these aspects or examples, but is only defined by the authorized claims and their equivalents. Various elements in the aspects or examples may be omitted or may be replaced by equivalent elements thereof. Further, the steps may be performed in an order different from that described in the present disclosure. Further, various elements in the aspects or examples may be combined in various ways. Importantly, with the evolution of the technology, many elements described herein may be replaced by equivalent elements appearing after the present disclosure.

**Claims**

1. A computer-implemented method for floating-point conversion, comprising:

   determining (201), for a floating-point number to be converted, the exponent data and mantissa data of the floating-point number; and

in response to the floating-point conversion being a floating-point rounding normalization, performing (202):

determining (203), based on the exponent data and the mantissa data, the exponent value of the floating-point number, wherein the exponent value of the floating-point number is the corresponding power value of the floating-point number;

concatenating (204), in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data;

performing (205), based on the exponent value of the floating-point number, a first left-shift operation on the first concatenated data to determine first intermediate data;

determining (206), based on the exponent value and the mantissa data of the floating-point number, a carry amount of the floating-point number, wherein the carry amount of the floating-point number indicates whether a carry occurs during the floating-point rounding normalization;

performing (207), in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization;

and determining (208), based on the exponent value of the floating-point number, the second intermediate data and the overflow variable, a normalized floating-point number corresponding to the floating-point number.

2. The method according to claim 1, wherein the performing, in response to the carry amount of the floating-point number indicating that a carry occurs during the floating-point rounding conversion, a carry operation on the first part of the first intermediate data to determine the second intermediate data and the overflow variable comprises:

performing an add-1 operation on the last bit of the first part of the first intermediate data to determine the second intermediate data; and

setting, in response to an overflow occurring when performing the add-1 operation on the last bit of the first part of the first intermediate data, the overflow variable to indicate that an overflow occurs when a carry occurs during the floating-point rounding normalization; and

setting, in response to no overflow occurring when performing the add-1 operation on the last bit of the first part of the first intermediate data, the overflow variable to indicate that no overflow occurs when a carry occurs during the floating-point rounding normalization, or

wherein the performing, in response to the carry amount of the floating-point number indicating that a carry occurs during the floating-point rounding conversion, a carry operation on the first part of the first intermediate data to determine the second intermediate data and the overflow variable further comprises:

setting, in response to all bits of the first part of the first intermediate data being 1, the overflow variable to indicate that an overflow occurs when a carry occurs during the floating-point rounding normalized, and setting the second intermediate data to all 0; and

setting, in response to not all bits of the first part of the first intermediate data being 1, the overflow variable to indicate that no overflow occurs when a carry occurs during the floating-point rounding normalization, and performing an add-1 operation on the last bit of the first part of the first intermediate data to determine the second intermediate data.

3. The method according to any one of claims 1-2, wherein the determining, based on the exponent value of the floating-point number , the second intermediate data and the overflow variable, the normalized floating-point number corresponding to the floating-point number comprises:

performing, based on the exponent value of the floating-point number, a second left-shift operation on the second intermediate data to determine third intermediate data;

concatenating a 0 to the right of the third intermediate data to determine the mantissa data of the normalized floating-point number; and

determining, based on the exponent value of the floating-point number and the overflow variable, the exponent data of the normalized floating-point number.

4. The method according to any one of claims 1-2, further comprising, in response to the floating-point conversion being a floating-point rounding normalization, performing:

performing, in response to the carry amount of the floating-point number indicating that no carry occurs during the floating-point rounding normalization, a second left-shift operation on the first part of the first intermediate data based on the exponent value of the floating-point number to determine fourth intermediate data;

concatenating a 0 to the right of the fourth intermediate data to determine the mantissa data of the normalized floating-point number; and

determining, based on the exponent value of the floating-point number, the exponent data of the normalized floating-point number, or

further comprising, in response to the floating-point conversion being a floating-point rounding normalization, performing:

setting, in response to the exponent value of the floating-point number being greater than or equal to the bit width of the mantissa data, the normalized floating-point number corresponding to the floating-point number to the floating-point number to be converted.

5. The method according to claim 1, further comprising:

determining the sign data of the floating-point number, and

the determining, based on the exponent value and the mantissa data of the floating-point number, the carry amount of the floating-point number comprises:

determining the carry amount of the floating-point number based on the mantissa data, the exponent value, the sign data of the floating-point number and the type of the floating-point rounding normalization, wherein the type of the floating-point rounding normalization is round-to-positive-infinity conversion, round-to-negative-infinity conversion, round-to-nearest-even conversion, or round-to-zero conversion.

6. The method according to any one of claims 1-2, further comprising:

in response to the floating-point conversion being a floating-point integer conversion, performing:

determining, based on the exponent data and the mantissa data, the exponent value of the floating-point number;

concatenating, in response to the exponent value of the floating-point number being less than the output bit width of the floating-point integer conversion, second padding data to the left of the mantissa data to determine second concatenated data, wherein the second padding data includes a second predetermined number of 0s and a **1,** wherein the second predetermined number is equal to the difference between the bit width of the integer number of the floating-point conversion and 1;

performing, based on the exponent value of the floating-point number, a third left-shift operation on the second concatenated data to determine fifth intermediate data;

determining, based on the exponent data and the mantissa data, the carry amount of the floating-point number; and

determining, based on the carry amount of the floating-point number and the fifth intermediate data, a rounded integer number of the floating-point number.

7. The method according to claim 6, wherein the first predetermined number is equal to the integer width of the floating-point conversion, and the first left-shift operation and the third left-shift operation are performed by the same shifter.

8. An apparatus for floating-point conversion, comprising:

a preprocessing module (901), configured to: determine, for a floating-point number to be converted, the exponent data and mantissa data of the floating-point number; and

a floating-point normalization module (902), comprising:

a first data determination unit (9021), configured to:

determine, based on the exponent data and the mantissa data, the exponent value of the floating-point number, wherein the exponent value of the floating-point number is the corresponding power value of the floating-point number;

a first data concatenating unit (9022), configured to: concatenate, in response to the exponent value of the floating-point number being less than the bit width of the mantissa data, first padding data to the left of the mantissa data to determine first concatenated data, wherein the first padding data includes a first predetermined number of 1s, and the first predetermined number is greater than or equal to the bit width of the mantissa data;

a first left-shift unit (9023), configured to: perform, based on the exponent value of the floating-point number, a first left-shift operation on the first concatenated data to determine first intermediate data;

a carry amount determination unit (9024), configured to: determine, based on the exponent value of the floating-point number and the mantissa data, a carry amount of the floating-point number, wherein the carry amount of the floating-point number indicates whether a carry occurs during the floating-point rounding normalization;

a first carry unit (9025), configured to: perform, in response to the carry amount of the floating-point number indicating that a carry occurs during the floating-point rounding normalization, a carry operation on a first part of the first intermediate data to determine second intermediate data and an overflow variable, wherein the first part of the first intermediate data is the data in the first intermediate data that corresponds to a reserved part of the first padding data and reserved bits of the mantissa data, the bit width of the first part of the first intermediate data is equal to the difference between the bit width of the mantissa data and 1, and the overflow variable indicates whether an overflow occurs when a carry occurs during the floating-point rounding normalization; and

a first floating-point number determination unit (9026), configured to: determine, based on the exponent value of the floating-point number, the second intermediate data and the overflow variable, a normalized floating-point number corresponding to the floating-point number.

9. The apparatus according to claim 10, wherein the first carry unit comprises:

an addition sub-unit, configured to: perform an add-1 operation on the last bit of the first part of the first intermediate data to determine the second intermediate data; and

an overflow setting sub-unit, configured to: set, in response to an overflow occurring when performing the add-1 operation on the last bit of the first part of the first intermediate data, the overflow variable to indicate that an overflow occurs when a carry occurs during the floating-point rounding normalization, and set, in response to no overflow occurring when performing the add-1 operation on the last bit of the first part of the first intermediate data, the overflow variable to indicate that no overflow occurs when a carry occurs during the floating-point rounding normalization, or

wherein the first carry unit comprises:

an overflow setting sub-unit, configured to:
in response to all bits of the first part of the first intermediate data being 1, set the overflow variable to indicate that an overflow occurs when a carry occurs during the floating-point rounding normalization, and set the second intermediate data to all 0; and

an addition sub-unit, configured to: in response to not all bits of the first part of the first intermediate data being 1, set the overflow variable to indicate that no overflow occurs when a carry occurs during the floating-point rounding normalization, and perform an add-1 operation on the last bit of the first part of the first intermediate data to determine the second intermediate data.

10. The apparatus according the any one of claims 8-9, wherein the first floating-point number determination unit comprises:

a second left-shift sub-unit, configured to: perform, based on the exponent value of the floating-point number, a second left-shift operation on the second intermediate data to determine third intermediate data;

a mantissa determination sub-unit, configured to: concatenate a 0 to the right of the third intermediate data to determine the mantissa data of the normalized floating-point number; and

an exponent determination sub-unit, configured to: determine, based on the exponent value of the floating-point number and the overflow variable, the exponent data of the normalized floating-point number.

11. The apparatus according to any one of claims 8-9, wherein the floating-point normalization module further comprises:

a none carry unit, configured to: in response to the carry amount of the floating-point number indicating that no carry occurs during the floating-point rounding normalization, perform a second left-shift operation on the first part of the first intermediate data based on the exponent value of the floating-point number to determine the mantissa data of the normalized floating-point number, and determine the exponent data of the normalized floating-point number based on the exponent value of the floating-point number, or

wherein the floating-point normalization module further comprises:

a second floating-point number determination unit, configured to: set, in response to the exponent value of the floating-point number being greater than or equal to the bit width of the mantissa data, the normalized floating-point number corresponding to the floating-point number to the floating-point number to be converted.

12. The apparatus according to claim 8, wherein

the preprocessing module is further configured to: determine the sign data of the floating-point number, and the carry amount determination unit comprises:

a carry amount determination sub-unit, configured to: determine, based on the mantissa data, the exponent value, the sign data of the floating-point number and the type of the floating-point rounding normalization, the carry amount of the floating-point number, wherein the floating-point rounding normalization is rounding towards positive infinity conversion, rounding towards negative infinity conversion, rounding to nearest, ties to even conversion or rounding toward zero conversion.

13. The apparatus according to any one of claims 8-9, wherein the apparatus further comprises a floating-point integer conversion module, and the floating-point integer conversion module comprises:

a second data determination unit, configured to: determine, based on the exponent data and the mantissa data, the carry amount and exponent value of the floating-point number;

a second data concatenating unit, configured to: concatenate, in response to the exponent value of the floating-point number being less than the output bit width of the floating-point integer conversion, second padding data to the left of the mantissa data to determine second concatenated data, wherein the second padding data includes a second predetermined number of 0s and a **1,** wherein the second predetermined number is equal to the difference between the integer width of the floating-point conversion and 1;

a third left-shift unit, configured to: perform, based on the exponent value of the floating-point number, a third left-shift operation on the second concatenated data to determine fifth intermediate data; and

a second integer number determination unit, configured to: determine, based on the carry amount of the floating-point number and the fifth intermediate data, a rounded integer number of the floating-point number.

14. A chip, comprising an apparatus for floating-point conversion as claimed in any one of claims 8-13.

15. A computer program product comprising program code portions for performing the method of any one of claims 1 to 7 when the computer program product is executed on one or more computing devices.

**FIG. 1**

**200**

determine, for a floating-point number to be converted, the exponent data and the mantissa data of the floating-point number ~ S201

whether the floating-point conversion is a floating-point rounding normalization? S202

YES

determine, based on the exponent data and the mantissa data, the exponent value of the floating-point number ~ S203

concatenate, in response to the exponent value of the floating-point number being less than the bit width of the mantissa data, first padding data to the left of the mantissa data to determine first concatenated data ~ S204

perform, based on the exponent value of the floating-point number, a first left-shift operation on the first concatenated data to determine first intermediate data ~ S205

determine, based on the exponent value and the mantissa data, a carry amount of the floating-point number ~ S206

perform, in response to the carry amount of the floating-point number indicating that a carry occurs during the floating-point rounding normalization, a carry operation on a first part of the first intermediate data to determine second intermediate data and an overflow variable ~ S207

determine, based on the exponent value of the floating-point number, the second intermediate data and the overflow variable, a normalized floating-point number corresponding to the floating-point number ~ S208

**FIG. 2**

**300**

| 1 | 1 | 1 | 1 | 1 | 1 | ⋯ | 1 | 1 | X | X | X | X | X | X | X | ⋯ | X | X |

**FIG. 3A**

the position
corresponding
to the binary
point

left-shift

<u>300</u>

| 1 | 1 | ... | 1 | 1 | ... | 1 | 1 | X | X | X | ... | X | X | X | 0 | ... | 0 | 0 |

the position of the
hidden leading bit 1

the first part

**FIG. 3B**

the position
corresponding to
the binary point

<u>400</u>

| 1 | 1 | ... | 1 | 1 | ... | 1 | 1 | X | X | X | ... | X | X | X | 0 | ... | 0 | 0 |

the first part

**FIG. 4A**

<u>400</u>

the position
corresponding to
the binary point

rounding carry

| 1 | ... | 1 | 1 | X | X | X | ... | X |

the first part

**FIG. 4B**

the position **400**
corresponding to the
binary point

| 1 | ... | 1 | 1 | Y | Y | Y | ... | Y |
|---|-----|---|---|---|---|---|-----|---|

the second intermediate data

**FIG. 4C**

the position **400**
corresponding to the
binary point

| 0 | ... | 0 | 0 | 0 | 0 | 0 | ... | 0 |
|---|-----|---|---|---|---|---|-----|---|

the second intermediate data

**FIG. 4D**

the position
corresponding to
the binary point

rounding carry **500**

| 1 | 1 | ... | 1 | 1 | ... | 1 | 1 | X | X | X | ... | X | X | X | 0 | ... | 0 | 0 |
|---|---|-----|---|---|-----|---|---|---|---|---|-----|---|---|---|---|-----|---|---|

the first part

**FIG. 5A**

the position
corresponding to
the binary point

**500**

| 1 | 1 | ... | 1 | 1 | ... | 1 | 1 | Y | Y | Y | ... | Y | X | X | 0 | ... | 0 | 0 |

the first part

**FIG. 5B**

**500**

the position
corresponding to
the binary point

| 1 | ... | 1 | 1 | Y | Y | Y | ... | Y |

the second intermediate data

**FIG. 5C**

the position
corresponding to
the binary point

**500**

| 0 | 0 | ... | 0 | 0 | ... | 0 | 0 | 0 | 0 | 0 | ... | 0 | X | X | 0 | ... | 0 | 0 |

the first part

**FIG. 5D**

the position
corresponding **500**
to the binary
point

| 0 | ... | 0 | 0 | 0 | 0 | 0 | ... | 0 |

the second intermediate data

**FIG. 5E**

**600**

left-shift

pad 0 to the least
significant bit

| 1 | ... | 1 | 1 | Y | Y | Y | ... | Y | 0 |

the second intermediate data

**FIG. 6A**

**600**

| Y | Y | Y | ... | Y | 0 | 0 | ... | 0 | 0 |

the third intermediate data

**FIG. 6B**

**600**

pad 0 to the least
significant bit

left-shift

| 1 | ... | 1 | 1 | X | X | X | ... | X | 0 |

the first part

**FIG. 6C**

**600**

| X | X | X | ... | X | 0 | 0 | ... | 0 | 0 |

the third intermediate data

**FIG. 6D**

**700**

```
┌─────────────────────────────────────┐
│ determine, for a floating-point number to be │
│ converted, the exponent data and mantissa data │───  S701
│     of the floating-point number     │
└─────────────────────────────────────┘
                    │
                    ▼
        ◇─────────────────────◇              S702
   ◇ whether the floating-point conversion is a ◇─────── NO ──────▶ ( A )
        ◇ floating-point rounding normalization? ◇
        ◇─────────────────────◇
                    │ YES
                    ▼
┌─────────────────────────────────────┐
│  determine, based on the exponent data and the │
│    mantissa data, the exponent value of the    │───  S703
│          floating-point number                 │
└─────────────────────────────────────┘
                    │
                    ▼
┌─────────────────────────────────────┐
│ concatenate, in response to the exponent value │
│ of the floating-point number being less than the │
│ bit width of the mantissa data, first padding    │───  S704
│   data to the left of the mantissa data to       │
│       determine first concatenated data          │
└─────────────────────────────────────┘
                    │
                    ▼
┌─────────────────────────────────────┐
│  perform, based on the exponent value of the │
│         floating-point number, a first left-shift │───  S705
│      operation on the first concatenated data to  │
│          determine first intermediate data        │
└─────────────────────────────────────┘
                    │
                    ▼
┌─────────────────────────────────────┐
│   determine, based on the exponent value and │
│   mantissa data, a carry amount of the floating- │───  S706
│             point number                         │
└─────────────────────────────────────┘
                    │
                    ▼
┌─────────────────────────────────────┐
│  perform, in response to the carry amount of the │
│  floating-point number indicating that a carry   │
│   occurs during the floating-point rounding      │
│ normalization, a carry operation on a first part │───  S707
│   of the first intermediate data to determine    │
│    second intermediate data and an overflow      │
│                  variable                        │
└─────────────────────────────────────┘
                    │
                    ▼
┌─────────────────────────────────────┐
│  determine, based on the exponent value of the │
│ floating-point number, the second intermediate │
│  data and the overflow variable, a normalized  │───  S708
│ floating-point number corresponding to the     │
│          floating-point number                 │
└─────────────────────────────────────┘
```

**FIG. 7A**

<u>**700**</u>

A

determine, based on the exponent data and mantissa data, the exponent value of the floating-point number    ∿ S709

concatenate, in response to the exponent value of the floating-point number being less than the output bit width of the floating-point integer conversion, second padding data to the left of the mantissa data to determine second concatenated data    ∿ S710

perform, based on the exponent value of the floating-point number, a third left-shift operation on the second concatenated data to determine fifth intermediate data    ∿ S711

determine, based on the exponent value and mantissa data, a carry amount of the floating-point number    ∿ S712

determine, based on the carry amount of the floating-point number and the fifth intermediate data, a rounded integer number of the floating-point number    ∿ S713

**FIG. 7B**

<u>**800**</u>

| 0 | 0 | 0 | 0 | 0 | 0 | ··· | 0 | 1 | X | X | X | X | X | X | X | ··· | X | X |

**FIG. 8A**

the position
corresponding to
the binary point

left-shift

800

| 0 | ⋯ | 0 | 1 | X | X | X | X | X | X | X | ⋯ | X | X | X | 0 | ⋯ | 0 | 0 |

the position of the
hidden leading bit 1

**FIG. 8B**

apparatus 900

preprocessing module901

floating-point normalization module902

first data determination unit
9021

first data concatenating unit
9022

first left-shift unit
9023

carry amount determination
unit9024

first carry unit
9025

first floating-point number
determination unit9026

**FIG. 9**

1000

1001
computing
unit

1002
ROM

1003
RAM

1004

1005
I/O interface

1006
input unit

1007
output unit

1008
storage unit

1009
communication
unit

**FIG. 10**